Europäisches Patentamt

European Patent Office

Office européen des brevets

(11) Numéro de publication: · **0 161 215 B1**

## FASCICULE DE BREVET EUROPEEN

(45) Date de publication de fascicule du brevet:
28.08.91

(51) Int. Cl.⁵: **H03F 1/30, H03F 3/45**

(21) Numéro de dépôt: **85810194.2**

(22) Date de dépôt: **30.04.85**

(54) Amplificateur à compensation de la tension de décalage d'entrée.

(30) Priorité: **04.05.84 CH 2179/84**

(43) Date de publication de la demande:
**13.11.85 Bulletin 85/46**

(45) Mention de la délivrance du brevet:
**28.08.91 Bulletin 91/35**

(84) Etats contractants désignés:
**DE FR GB**

(56) Documents cités:
**US-A- 3 443 235**
**US-A- 4 068 182**
**US-A- 4 297 642**

**IBM TECHNICAL DISCLOSURE BULLETIN, vol. 15, no. 1, juin 1972, page 140, 141, New York, US; G.A. HELLWARTH et al.: "Automatic zero-correction amplifier"**

**IDEM**

(73) Titulaire: **CENTRE ELECTRONIQUE HORLOGER S.A.**
**Maladière 71**
**CH-2000 Neuchâtel 7(CH)**

(72) Inventeur: **Vittoz, Eric A.**
**Bois du Pâquier 15**
**CH-2053 Cernier(CH)**
Inventeur: **Oguey, Henri J.**
**Chemin des Vignes 5**
**CH-2035 Corcelles(CH)**

(74) Mandataire: **Brulliard, Joel**
**c/o Centre Suisse d'Electronique et de Microelectronique S.A. Maladière 71**
**CH-2000 Neuchâtel 7(CH)**

## Description

La présente invention se rapporte à un amplificateur réalisé en technologie MOS et comportant des moyens pour compenser le décalage de la tension d'entrée.

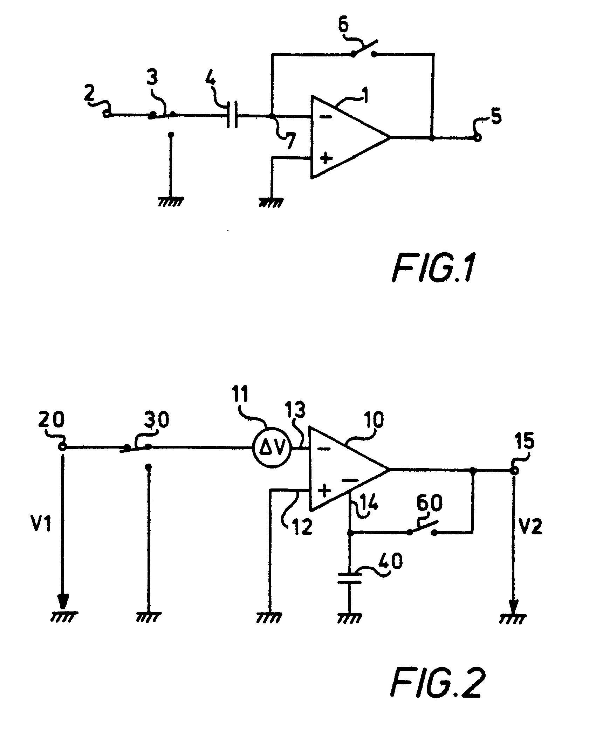

On connaît déjà des moyens pour éviter les limitations des technologies MOS standards, notamment pour compenser le niveau relativement élevé de la tension de décalage d'entrée des circuits amplificateurs. Le principe de base consiste à mémoriser, dans une capacité MOS, la tension de décalage d'entrée et à utiliser la grandeur ainsi mémorisée pour corriger l'information fournie par l'amplificateur. Un premier exemple d'application de ce principe peut être trouvé dans l'article de Yen S. Yee et al intitulé "A 1 mV MOS Comparator", paru dans IEEE Journal of Solid-State Circuits, Vol. SC-13, No 3, Juin 1978, pp. 294-297. Un schéma de principe du circuit décrit dans cet article est représenté à la figure 1. L'entrée de l'amplificateur 1 est connectée à la borne d'entrée 2 par l'intermédiaire d'un commutateur 3 et d'un condensateur 4 et à la borne de sortie 5 par l'intermédiaire d'un interrupteur 6. Ce circuit fonctionne en deux phases. Pendant la phase de mémorisation, l'amplificateur est bouclé en gain unité par la fermeture de l'interrupteur 6 et le commutateur 3 relie une borne du condensateur 4 à la masse. A l'équilibre, la tension de décalage d'entrée apparaissant au noeud d'entrée 7 de l'amplificateur est alors mémorisée dans le condensateur 4. Pendant la phase d'amplification, l'interrupteur 6 est ouvert et l'entrée 2 est reliée au condensateur 4 à travers le commutateur 3, la tension mémorisée dans le condensateur 4 servant à compenser l'effet de la tension de décalage d'entrée de l'amplificateur 1. L'inconvénient majeur d'une telle méthode de compensation provient du fait que les interrupteurs sont réalisés à l'aide de transistors MOS. Ainsi lors du blocage du transistor qui constitue l'interrupteur 6, une partie de la charge de canal est réinjectée au noeud 7, ce qui modifie la tension mémorisée dans le condensateur 4 et cette modification peut être du même ordre de grandeur que la tension de décalage d'entrée à compenser.

Un deuxième exemple d'application est montré dans l'article de R. Poujois et al intitulé "A low Drift Fully Integrated MOSFET Operational Amplifier" paru dans la revue précitée, Vol. SC-13, No 4, Août 1978, pp. 499-503. Cet article prévoit la mise en cascade de plusieurs étages amplificateurs couplés par des condensateurs qui mémorisent la valeur de la tension de décalage d'entrée de l'étage qui les précède, multipliée par le gain de cet étage. Cette méthode est d'autant plus efficace que le nombre d'étages est grand, ce qui constitue en soi un inconvénient. Par ailleurs, il est difficile d'assurer la stabilité d'un amplificateur composé de plusieurs étages à l'aide d'une contre-réaction sans réduire de manière importante sa largeur de bande. Si une telle méthode peut être appliquée à la réalisation d'un comparateur, elle est, par contre, difficilement applicable à la réalisation d'un amplificateur opérationnel.

Aussi un objet de la présente invention est un circuit amplificateur ne présentant pas les inconvénients mentionnés ci-dessus.

Un autre objet de l'invention est un circuit amplificateur, comportant des moyens pour compenser la tension de décalage d'entrée.

Encore un autre objet de l'invention est un circuit amplificateur dans lequel l'effet de l'injection de charges, lors de l'ouverture d'interrupteurs, est minimisé.

La présente invention sera mieux comprise à l'aide de la description d'exemples de réalisation particuliers, ladite description étant faite à titre purement illustratif et en liaison avec les dessins joints dans lesquels:

- la figure 1 est un schéma de principe d'un amplificateur connu dans l'art antérieur;
- la figure 2 est un schéma de principe d'un amplificateur;
- la figure 3 montre un amplificateur différentiel à compensation linéaire de la tension de décalage d'entrée;
- la figure 4 montre un amplificateur différentiel à compensation quadratique de la tension de décalage d'entrée;
- la figure 5 montre une variante du circuit de la figure 4; et
- la figure 6 montre un amplificateur de type dynamique à compensation quadratique de la tension de décalage d'entrée.

La figure 2 est un schéma de principe d'un circuit amplificateur. Il comporte un amplificateur 10 ayant une entrée directe 12, une première entrée inverse ou entrée principale 13, une sortie 15 et une deuxième entrée inverse ou entrée secondaire 14. L'entrée directe 12 est reliée à la masse. L'entrée principale 13 peut être reliée, soit à la borne d'entrée 20, soit à la masse, au moyen d'un commutateur 30. L'entrée secondaire 14 est reliée d'une part, à la masse par l'intermédiaire d'un condensateur 40 et d'autre part, à la sortie 15 de l'amplificateur à travers un interrupteur 60. L'élément 11 symbolise une source de tension de valeur $\Delta V$ représentant la tension de décalage de l'entrée principale 13 de l'amplificateur 10. Selon l'invention, le gain de l'amplificateur 10 est plus grand vu de l'entrée principale 13 que vu de l'entrée secondaire 14. Le circuit de la figure 2 fonctionne en deux phases successives: la phase de compensation et la phase d'amplification.

Pendant la phase de compensation, les deux entrées 12 et 13 sont reliées à la masse par le commutateur 30 et l'entrée secondaire 14 est reliée à la sortie 15 par l'interrupteur 60. La tension nécessaire pour compenser l'effet de la tension de décalage d'entrée ΔV est mémorisée dans le condensateur 40. A la fin de la phase de compensation, l'interrupteur 60 est ouvert puis le commutateur 30 est positionné de manière à relier l'entrée principale 13 a la borne d'entrée 20. Si l'interrupteur 60 est constitué par un transistor MOS, le blocage de celui-ci (ouverture de l'interrupteur 60) a pour effet d'injecter des charges dans le condensateur 40, modifiant ainsi la valeur précédemment mémorisée. Cependant l'effet de cette injection de charges sur la compensation de la tension de décalage d'entrée sera d'autant plus faible que le gain de l'amplificateur relatif a l'entrée secondaire sera bas vis-à-vis du gain de l'amplificateur relatif à l'entrée principale.

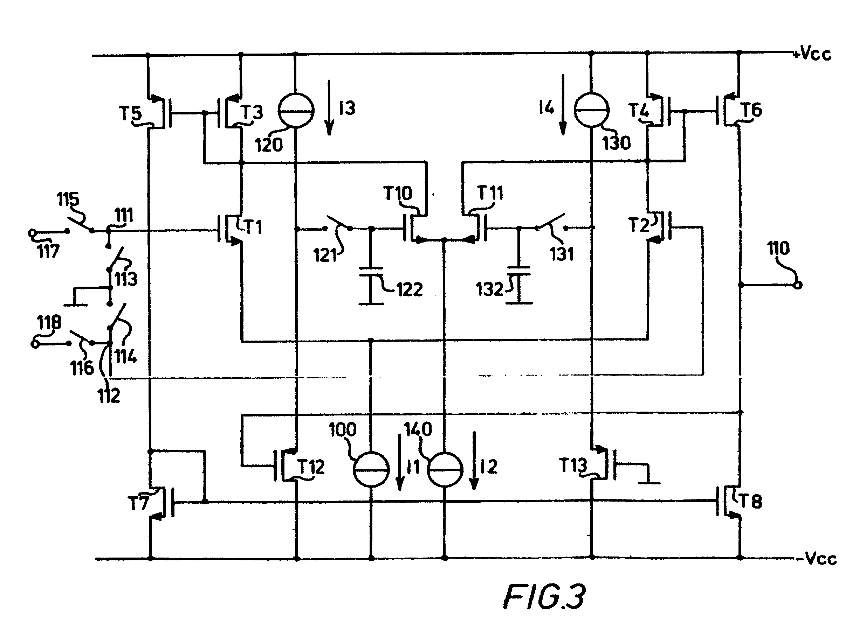

Une première forme d'exécution en technologie CMOS du circuit amplificateur de la figure 2 est montrée à la figure 3. On reconnaît une paire différentielle d'entrée constituée par les transistors à canal n, T1 et T2, dont les sources sont connectées à la borne d'alimentation -Vcc du circuit par l'intermédiaire d'une source de courant 100 et dont les drains sont couplés par l'intermédiaire de trois miroirs de courant. Ces trois miroirs de courant sont constitués par les transistors à canal p, T3 et T5, dont les sources sont reliées à la borne d'alimentation +Vcc du circuit, par les transistors à canal n, T7 et T8, dont les sources sont reliées à -Vcc et par les transistors à canal p, T6 et T4, dont les sources sont reliées à +Vcc. Le point commun aux drains des transistors T6 et T8 est relié à la borne 110, qui constitue la sortie de l'amplificateur tandis que les grilles des transistors T1 et T2 sont reliées aux bornes 111 et 112, qui constituent respectivement l'entrée principale inverse et l'entrée directe de l'amplificateur. Un tel schéma d'amplificateur à entrées différentielles est bien connu et peut être trouvé, par exemple, dans l'article de F. Krummenacher, intitulé "High voltage Gain CMOS OTA for Micropower SC Filter" paru dans Electronics Letters, 19 Février 1981, Vol. 17, No 4.

Des moyens interrupteurs 113 à 116 sont prévus pour, d'une part, relier chacune des entrées 111 et 112 à la masse pendant la phase de compensation et, d'autre part, relier, pendant la phase d'amplification, les grilles de T1 et T2 aux bornes d'entrée 117 et 118 respectivement, sur lesquelles sont appliqués les signaux d'entrée. La sortie 110 est également reliée à la grille d'un transistor à canal p, T12, connecté en série avec une source de courant 120 entre les bornes d'alimentation du circuit et constituant un étage suiveur de tension. La sortie de cet étage suiveur est reliée, à travers un interrupteur 121, à un condensateur 122 et à la grille d'un transistor à canal n, T10. Le transistor T10 constitue, avec le transistor T11, une paire différentielle analogue à celle formée par les transistors T1 et T2. Les sources de T10 et T11 sont connectées à -Vcc par l'intermédiaire d'une source de courant 140 tandis que les drains sont reliés aux drains de T1 et T2 respectivement. Les éléments constitués par le transistor T13, la source de courant 130, l'interrupteur 131 et le condensateur 132 sont connectés de manière symétrique des éléments correspondants T12, 120, 131 et 132 et ont pour but de diminuer l'effet d'une injection de charges lors de l'ouverture des interrupteurs en symétrisant l'ensemble du circuit. La grille du transistor T13 est reliée à la masse bien que, dans le cas d'un amplificateur à entrées et sorties différentielles, elle pourrait être reliée a l'autre sortie de l'amplificateur.

Par ailleurs, bien que l'on ait prévu de relier, pendant la phase de compensation, les bornes d'entrée 111 et 112 à la masse, il peut être avantageux de les relier simplement entre elles pendant cette phase, annulant ainsi le signal d'entrée.

Quant aux condensateurs 122 et 132, il est clair qu'une de leurs bornes pourrait être reliée a un point à un potentiel fixe quelconque au lieu d'être reliée à la masse.

Nous avons vu, en relation avec la figure 2, que le gain de l'amplificateur relatif à l'entrée principale, soit A1, doit être plus élevé que celui, A2, relatif à l'entrée secondaire. Le rapport de ces deux gains est donné par la relation:

$$\frac{A2}{A1} = \frac{g_{m2}}{g_{m1}} \; ;$$

où $g_{m1}$ et $g_{m2}$ sont les transconductances des transistors T10 et T1 respectivement. Ce rapport peut encore s'exprimer par:

$$\frac{A2}{A1} = \frac{I2}{I1} \cdot \frac{(V_{GS}-V_T)_{T1}}{(V_{GS}-V_T)_{T10}} \; ;$$

où I1 et I2 sont les courants fournis respectivement par les sources de courant 100 et 140, $V_{GS}$ est la tension grille-source du transistor T1, respectivement du transistor T10, et $V_T$ est la tension de seuil du transistor T1, respectivement du transistor T10. Pour que le rapport des gains A2/A1 soit faible, il faut que le rapport des courants I2/I1 soit faible et que $(V_{GS}-V_T)_{T1}$ soit faible vis-à-vis de $(V_{GS}-V_T)_{T10}$. En pratique, le rapport I2/I1 est limité par l'erreur maximale du courant à corriger, et les transistors T1 et T10 seront dimensionnés de manière que le transistor T1 fonctionne à la limite du régime de faible inversion (grande valeur de $g_m$) et que la différence $V_{GS}-V_T$ du transistor T10 présente une valeur aussi proche que possible de la tension d'alimentation. Tous les interrupteurs du circuit sont réalisés à l'aide de transistors MOS.

Le fonctionnement de l'amplificateur de la figure 3 est le suivant. Pendant la phase de compensation, les entrées 111 et 112 sont reliées à la masse par les interrupteurs 113 et 114, ou sont reliées simplement entre elles, et les grilles des transistors T10 et T11 sont reliées aux sources des transistors T12 et T13, par les interrupteurs 121 et 131 respectivement. Le condensateur 122 est alors chargé à la tension de la sortie 110, transférée par l'étage suiveur 120-T12 et qui représente la tension nécessaire pour compenser la tension de décalage des entrées principales. Pendant la phase d'amplification, les interrupteurs 113, 114, 121 et 131 sont ouverts et les entrées 111 et 112 sont reliées aux bornes d'entrée 117 et 118 par les interrupteurs 115 et 116, respectivement. La tension mémorisée dans le condensateur 122, respectivement 132, rend plus ou moins conducteur le transistor T10, respectivement T11, ce qui a pour effet de diminuer plus ou moins le courant traversant le transistor T1, respectivement T2.

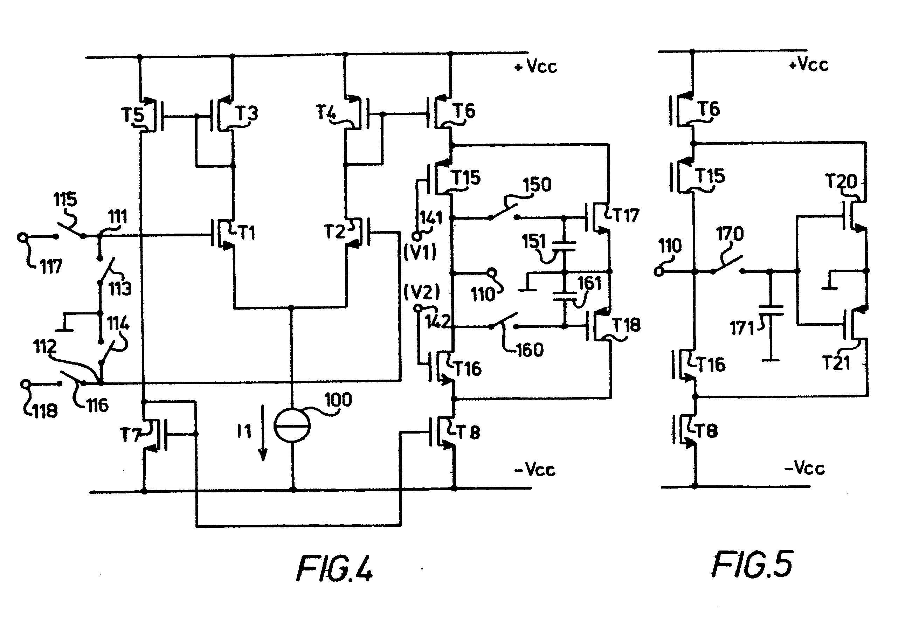

Le circuit de la figure 3 comporte une compensation améliorée de la tension de décalage d'entrée. Le circuit de la figure 3 met en oeuvre une compensation de type linéaire. En fait, il n'est pas nécessaire d'assurer une relation linéaire entre l'entrée secondaire et la sortie de l'amplificateur. Une solution particulièrement intéressante consiste à utiliser une caractéristique quadratique de compensation. Le schéma de la figure 4 montre un circuit correspondant à cette solution.

Le circuit de la figure 4 est basé sur un amplificateur à entrées différentielles du même type que celui de la figure 3; aussi les éléments communs aux deux schémas portent-ils les mêmes références. Dans le schéma de la figure 4, l'étage de sortie, formé par les transistors T6 et T8, est complété par un montage de type cascode constitué par le transistor à canal p, T15 et le transistor à canal n, T16. Les transistors T15 et T16 sont connectés en série entre les transistors T6 et T8 et sont polarisés en appliquant sur les grilles 141 et 142 des tensions de valeur convenable V1 et V2, respectivement. Le point commun aux drains des transistors T15 et T16 est relié à la borne 110 de sortie de l'amplificateur. Un tel montage est bien connu et est décrit, par exemple, dans l'article précité de F. Krummenacher.

Le circuit de compensation se compose de deux transistors T17 et T18, deux condensateurs 151 et 161 et de deux interrupteurs 150 et 160. Le transistor à canal p, T18, est connecté entre le point commun aux transistors T8 et T16 et la masse et sa grille est reliée d'une part, au condensateur 161 et d'autre part, à la sortie de l'amplificateur par l'intermédiaire de l'interrupteur 160. Le transistor à canal n, T17, est connecté entre le point commun aux transistors T6 et T15 et la masse et sa grille est reliée d'une part, au condensateur 151 et d'autre part, à la sortie de l'amplificateur par l'intermédiaire de l'interrupteur 150.

Pendant la phase de compensation, les entrées principales 111 et 112 de l'amplificateur sont reliées à la masse, ou simplement entre elles comme indiqué précédemment, et les condensateurs 151 et 161 sont reliés à la sortie de l'amplificateur par la fermeture des interrupteurs 150 et 160. La tension de compensation du décalage d'entrée qui apparaît sur la sortie 110 sera mémorisée dans les condensateurs 151 et 161. Pendant la phase d'amplification, les entrées 111 et 112 sont reliées aux bornes d'entrée 117 et 118, respectivement et les interrupteurs 150 et 160 sont ouverts. Si la tension de compensation du décalage sur la sortie 110 est positive, la compensation sera effectuée par le transistor T17 commandé par la tension aux bornes du condensateur 151. Si, à l'inverse, cette tension de compensation du décalage est négative, la compensation sera effectuée par le transistor T18 commandé par la tension aux bornes du condensateur 161.

Comme pour le circuit de la figure 3, les interrupteurs sont réalisés à l'aide de transistors MOS. L'interrupteur 150 est réalisé avec un transistor à canal p et l'interrupteur 160 est réalisé avec un transistor à canal n. Si nécessaire, des amplificateurs montés en suiveurs peuvent être disposés en série avec les interrupteurs 150 et 160 pour accélérer la phase de compensation.

En s'intéressant au cas où la tension de compensation du décalage a une valeur positive et en désignant par:

$V_S$, la tension de sortie de l'amplificateur;

A1, le gain de l'amplificateur relatif à l'entrée principale;

$V_E$, la tension d'entrée de l'amplificateur;

$\Delta V$, la tension de décalage d'entrée:

$\beta$, le gain du transistor T17;

$V_G$, la tension aux bornes du condensateur 151;

$V_T$, la tension de seuil du transistor T17;

$g_m$, la transconductance du transistor T1 ou du transistor T2;

on peut montrer que la tension de sortie $V_S$ s'exprime par la relation:

$$V_S = -A1\,(V_E - \Delta V) - \frac{\beta . A1}{2\,g_m}\,(V_G - V_T)^2$$

Cette relation montre bien une caractéristique quadratique de la compensation opérée par le circuit de la figure 4.

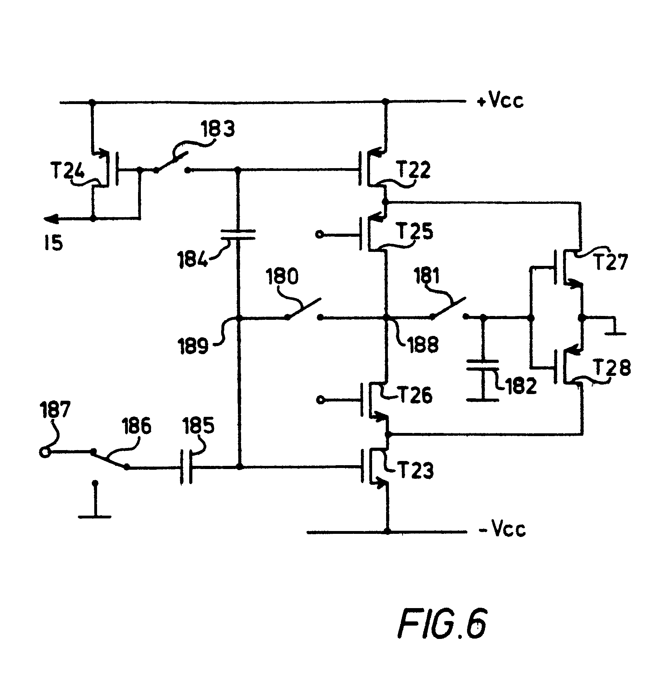

Une variante de circuit de compensation à caractéristique quadratique est montrée à la figure 5, dans laquelle seul l'étage de sortie de l'amplificateur a été représenté, tous les autres éléments étant identiques à ceux de la figure 4. Le transistor à canal n, T20, est connecté entre le point commun aux transistors T6 et T15 et la masse. Le transistor à canal p, T21, est connecté entre le point commun aux transistors T8 et T16 et la masse. Les grilles des transistors T20 et T21 sont reliées entre elles et au condensateur 171 ainsi qu'à la sortie 110 de l'amplificateur à travers l'interrupteur 170. L'interrupteur 170 est réalisé au moyen de deux transistors MOS de types complémentaires mis en parallèle. Le fonctionnement du circuit de la figure 5 est analogue à celui du circuit de la figure 4, la compensation étant assurée par le transistor T20 ou le transistor T21, selon le signe de la tension mémorisée dans le condensateur 171.

Lorsque la tension de décalage d'entrée de l'amplificateur devant être compensée est de valeur élevée (plusieurs centaines de millivolts), il est dans ce cas avantageux de combiner une méthode de compensation connue dans l'art antérieur, telle celle décrite en relation avec la figure 1, avec la méthode de compensation décrite précédemment. La figure 6 montre un exemple d'amplificateur dans lequel les deux méthodes de compensation sont combinées. L'amplificateur de la figure 6 est du type dynamique et il est décrit dans le brevet suisse de la requérante No 639 804. Il comporte une source de tension de polarisation constituée par le transistor T24, monté en diode et commandé par un courant de drain 15, et un étage d'amplification constitué par les transistors de types complémentaires T22 et T23 auxquels est associé un montage de type cascode, formé par les transistors T25 et T26. Le noeud 189, qui constitue le noeud d'entrée de l'amplificateur, est relié à la grille du transistor T23, à la grille du transistor T22 par l'intermédiaire d'un condensateur 184 et à la borne d'entrée 187 à travers un condensateur 185 et un commutateur 186. Le noeud d'entrée 189 est relié au noeud de sortie 188 par un interrupteur 180. On rappellera brièvement le fonctionnement de cet amplificateur. Pendant la phase de préparation, le commutateur 186 est relié à la masse et les interrupteurs 180 et 183 sont fermés. Les condensateurs sont alors chargés à une valeur qui polarisera les transistors T22 et T23. Les transistors T25 et T26 sont eux polarisés de manière connue par des tensions appliquées sur leur grille. Pendant la phase d'amplification, les interrupteurs 180 et 183 sont ouverts et le commutateur 186 est relié a la borne d'entrée du signal 187. Lors de l'ouverture, les interrupteurs 180 et 183 injectent une charge parasite dans les condensateurs 184 et 185. Cet effet parasite peut être compensé, selon l'invention, a l'aide d'un circuit de compensation identique à celui décrit en relation avec la figure 5 et comportant l'interrupteur 181, le condensateur 182 et les transistors de types complémentaires T27 et T28. Lorsqu'il est associé au circuit de compensation selon l'invention, le fonctionnement de l'amplificateur dynamique est le suivant. Pendant la phase de préparation, l'interrupteur 181 est ouvert, les interrupteurs 180 et 183 sont fermés et le commutateur 186 relie le condensateur 185 à la masse. Ensuite, l'interrupteur 181 est fermé tandis que les interrupteurs 180 et 183 sont ouverts. Enfin, le commutateur 186 relie le condensateur 185 à la borne d'entrée 187 pour la phase d'amplification.

**Revendications**

1. Amplificateur ayant au moins une entrée principale (189), une sortie (188), un premier condensateur (185) en série avec ladite entrée principale, des moyens (186) pour relier, pendant une phase de compensation, ledit premier condensateur (185) à une tension de référence et un dispositif interrupteur (180) reliant, pendant la phase de compensation, ladite entrée principale à ladite sortie; ledit amplificateur étant caractérisé en ce qu'il comporte en outre:

- au moins une entrée secondaire inverse présentant un gain sensiblement moins élevé que celui de l'entrée principale;
- un condensateur (182) connecté entre ladite entrée secondaire et un point à un potentiel fixe;
- des moyens interrupteurs (181), disposés entre la sortie de l'amplificateur et le point commun audit condensateur et à ladite entrée secondaire et permettant de mémoriser dans ledit condensateur, pendant ladite phase de compensation, le niveau de tension de la sortie de l'amplificateur ; et
- des moyens de compensation (T27,T28), commandés par ledit niveau de tension mémorisé, pour compenser l'effet de la tension résiduelle de décalage de ladite entrée principale ainsi que l'effet de l'ouverture dudit dispositif interrupteur.

2. Amplificateur selon la revendication 1, caractérisé en ce qu'un circuit d'adaptation d'impédance est prévu, en série avec lesdits moyens interrupteurs, entre la sortie de l'amplificateur et ladite entrée secondaire.

3. Amplificateur selon la revendication 1 ou la revendication 2, caractérisé en ce que lesdits moyens de compensation ont une caractéristique de transfert linéaire.

4. Amplificateur selon la revendication 1 ou la revendication 2, caractérisé en ce que lesdits moyens de compensation ont une caractéristique de transfert quadratique.

**Claims**

1. Amplifier having at least one main input (189), an output (188), a first capacitor (185) in series with the said main input, means (186) for connecting, during a compensation phase, the said first capacitor (185) to a reference voltage and a switching device (180) connecting, during the compensation phase, the said main input to the said output; the said amplifier being characterised in that it incorporates in addition:
- at least one inverting secondary input having a gain substantially lower than that of the main input;
- a capacitor (182) connected between the said secondary input and a point at a fixed potential;
- switching means (181), disposed between the amplifier output and the point common to the said capacitor and the said secondary input, making it possible to store in the said capacitor, during the said compensation phase, the amplifier output voltage level; and
- compensation means (T27, T28), controlled by the said stored voltage level, to compensate for the effect of the residual offset voltage of the said main input and the effect of the opening of the said switching device.

2. Amplifier according to claim 1, characterised in that an impedance matching circuit is provided, in series with the said switching means, between the amplifier output and the said secondary input.

3. Amplifier according to claim 1 or claim 2, characterised in that the said compensation means have a linear transfer characteristic.

4. Amplifier according to claim 1 or claim 2, characterised in that the said compensation means have a quadratic transfer characteristic.

**Patentansprüche**

1. Verstärker mit mindestens einem Haupteingang (189), einem Ausgang (188), einem ersten Kondensator (185) in Serie mit dem Haupteingang, Mitteln (186) zum Anlegen des ersten Kondensators (185) während einer Kompensationsphase an eine Referenzspannung und einer Unterbrecheranordnung (180), die während der Kompensationsphase den Haupteingang mit dem Ausgang verbindet, gekennzeichnet durch:
- mindestens einen inversen Sekundäreingang mit einer Verstärkung, die wesentlich weniger hoch ist als die des Haupteingangs,

- einen zwischen den Sekundäreingang und einen Festpotentialpunkt geschalteten Kondensator (182),
- Unterbrechermittel (181), angeordnet zwischen dem Ausgang des Verstärkers und dem diesem Kondensator und dem Sekundäreingang gemeinsamen Punkt, zum Ermöglichen der Speicherung während der Kompensationsphase des Spannungspegels vom Ausgang des Verstärkers auf dem Kondensator, und
- von dem gespeicherten Spannungspegel gesteuerte Kompensationsmittel (T27, T28) zum Kompensieren der Wirkung der Restversatzspannung des Haupteingangs wie auch der Wirkung des Öffnens der Unterbrecheranordnung.

2. Verstärker nach Anspruch 1, dadurch gekennzeichnet, daß eine Impedanzanpaßschaltung in Serie mit den Unterbrechermitteln zwischen dem Ausgang des Verstärkers und dem Sekundäreingang vorgesehen ist.

3. Verstärker nach Anspruch 1 oder 2, dadurch gekennzeichnet, daß die Kompensationsmittel eine lineare Transfercharakteristik haben.

4. Verstärker nach Anspruch 1 oder 2, dadurch gekennzeichnet, daß die Kompensationsmittel eine quadratische Transfercharakteristik haben.

FIG.1

FIG.2

FIG.3

EP 0 161 215 B1

FIG.4

FIG.5

EP 0 161 215 B1

FIG.6